(19)

Europäisches
Patentamt
European
Patent Office
Office européen
des brevets

(11) **EP 2 453 266 A1**

(12) **EUROPEAN PATENT APPLICATION**

(43) Date of publication:
**16.05.2012 Bulletin 2012/20**

(51) Int Cl.:
*G02B 5/08* (2006.01)          *H01G 9/20* (2006.01)
*H01L 51/42* (2006.01)          *H01M 14/00* (2006.01)

(21) Application number: **11186589.5**

(22) Date of filing: **25.10.2011**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **16.11.2010 KR 20100114029**

(71) Applicant: **Samsung SDI Co., Ltd.
Gyeonggi-do (KR)**

(72) Inventors:
  • **Shin, Byong-Cheol
    Gyeonggi-do (KR)**
  • **Lee, Ji-Won
    Gyeonggi-do (KR)**

• **Park, Do-Young
  Kyunggi-do (KR)**
• **Kang, Moon-Sung
  Kyunggi-do (KR)**
• **Kim, Chang-Wook
  Gyeonggi-do (KR)**
• **Cha, Si-Young
  Gyeonggi-do (KR)**
• **Park, Jae-Hyoung
  Gyeonggi-do (KR)**

(74) Representative: **Mounteney, Simon James
  Marks & Clerk LLP
  90 Long Acre
  London
  WC2E 9RA (GB)**

(54) **Dye-sensitized solar cell**

(57)    A dye-sensitized solar cell incudes a first electrode, a light absorption layer (23) disposed on one side of the first electrode, a second electrode facing the first electrode, a light reflecting layer (11) disposed on one side of the second electrode, and an electrolyte (30) filled between the first electrode and the second electrode.

Here, the light reflecting layer (11) includes a plurality of thin films including a first oxide thin film (11a) and a second oxide thin film (11b), the first oxide thin film (11a) has a different refractive index from the second oxide thin film (11b), and the first and second oxide thin films (11a,11b) are stacked alternately.

FIG.1

## Description

### BACKGROUND

1. **Field**

The invention relates to a dye-sensitized solar cell.

2. **Description of Reflated Art**

Diverse research has been carried out in an attempt to develop energy sources that can replace conventional fossil fuels and solve the approaching energy crisis. Particularly, extensive research is underway to find ways for using alternative energy sources, such as wind power, atomic power, and solar power, as substitutes for petroleum resources, which are expected to be depleted within several decades. Among the alternative energy sources, solar cells use solar energy that is infinite and environmentally friendly, as opposed to other energy sources. Since 1983 when a selenium (Se) solar cell was first produced, solar cells have been highlighted. Also, silicon(Si) solar cells have recently been drawing a lot of attention from researchers.

However, it is difficult to practically use Si solar cells because the production cost is high and there are difficulties in improving cell efficiency. To overcome the problems, researchers are studying development of a dye-sensitized solar cell that can be produced at a low cost.

A dye-sensitized solar cell typically includes photosensitive dye molecules that absorb visible rays and produce electron-hole pairs, excitons, and a transition metal oxide that transfers the produced electrons.

However, since the photosensitive dye is positioned in a dye-sensitized solar cell locally, a majority of light entered into the dye-sensitized solar cell may not reach the photosensitive dye. Additionally, because a photosensitive dye absorbs solar light having a specific wavelength region, there are limits for absorbing solar light.

### SUMMARY

The present invention is directed toward a dye-sensitized solar cell capable of improving efficiency.

According to one embodiment of the present invention, a dye-sensitized solar cell is provided that includes a first electrode, a light absorption layer disposed on one side of the first electrode, a second electrode facing the first electrode, a light reflecting layer disposed on one side of the second electrode and an electrolyte filled between the first electrode and the second electrode, wherein the light reflecting layer includes a plurality of thin films including a first oxide thin film and a second oxide thin film, the first oxide thin film having a different refractive index from the second oxide thin film, and the first and second oxide thin films being stacked alternately.

The first oxide thin film may include a titanium oxide ($TiO_2$), and the second oxide thin film may include a silicon oxide ($SiO_2$).

Each of the first oxide thin film and the second oxide thin film may be formed to have a thickness at 10nm or 800nm or between 10nm and 800nm.

The second oxide thin film may be formed thicker than the first oxide thin film.

The light reflecting layer may reflect light of wavelength at 380nm or 750nm or between 380nm and 750nm.

The light reflecting layer may have a light reflecting wavelength varying in accordance to the thicknesses of the first oxide thin film and the second oxide thin film.

The light reflecting layer may have a reflectance higher than about 100%.

The light absorption layer may include a titanium oxide ($TiO_2$) and a photosensitive dye adsorbed to $TiO_2$.

The second electrode may include Pt, Au, Ni, Cu, Ag, In, Ru, Pd, Rh, Ir, Os, C, a conductive polymer or a combination thereof.

At least one of the first electrode or the second electrode is supported by a conductive transparent substrate and the conductive transparent substrate may include indium tin oxide, fluorine tin oxide, $ZnO$-($Ga_2O_3$ or $Al_2O_3$), tin oxide, zinc oxide, or a combination thereof.

In view of the foregoing, the efficiency may be improved by increasing the optical amount absorbed by a dye-sensitized solar cell.

At least some of the above and other features of the invention are set out in the claims.

### BRIEF DESCRIPTION OF THE DRAWINGS

FIG. 1 is a cross-sectional view illustrating a dye-sensitized solar cell in accordance with an embodiment of the present invention.

FIG. 2 is a cross-sectional enlarged view enlarging a light reflecting layer of the dye-sensitized solar cell shown in FIG. 1.

FIGS. 3A to 3D are graphs showing the optical reflectances (diffusive reflectances) of dye-sensitized solar cells according to Examples 1 to 4.

FIG. 4 is a graph showing the current density of the dye-sensitized solar cells according to Example 4 and Comparative Example 1.

## DETAILED DESCRIPTION

Embodiments of the invention will hereinafter be described in detail. However, these embodiments are only examples, and the present invention is not limited thereto.

In the drawings, the thickness of layers, regions, etc., are exaggerated for clarity. Like reference numerals designate like elements throughout the specification. It is to be understood that when an element such as a layer, film, region, or substrate is referred to as being "on" another element, it can be directly on the other element or one or more intervening elements may also be present therebetween. In contrast, when an element is referred to as being "directly on" another element, there are no intervening elements present therebetween.

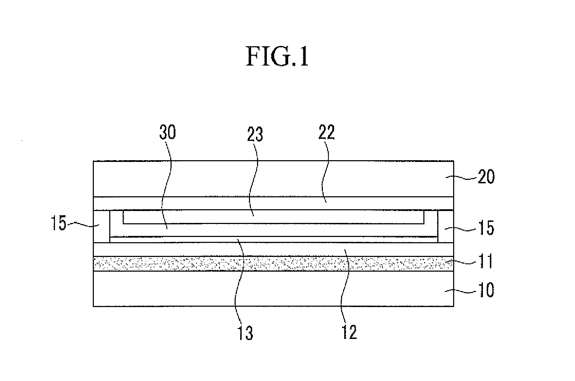

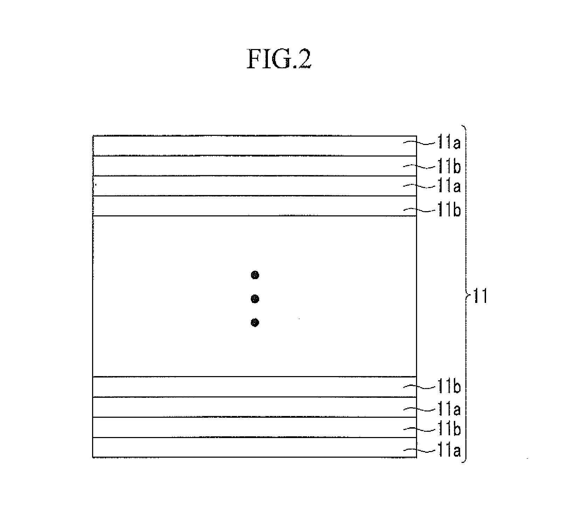

Hereinafter, a dye-sensitized solar cell according to one embodiment is described in detail referring to FIGS. 1 and 2.

Referring to FIG. 1, the dye-sensitized solar cell includes a lower substrate 10 and an upper substrate 20 which face (or oppose) each other and is fixed with a spacer 15; a lower electrode 12 and an upper electrode 22 which are respectively disposed on one side of the lower substrate 10 and the upper substrate 20; a light reflecting layer 11 disposed on one side of the lower electrode 12; an auxiliary electrode 13 disposed on the other side of the lower electrode 12; a light absorption layer 23 disposed on one side of the upper electrode 22; and an electrolyte 30 filling the space between the lower substrate 10 and the upper substrate 20.

The lower substrate 10 and the upper substrate 20 may be formed of transparent glass or polymer, and the polymer may include polyacrylate, polyethyleneetherphthalate, polyethyfenenaphthalate, polycarbonate, poly arylate, polyetherimide, polyethersulfone, and/or polyimide.

Each of the lower electrode 12 and the upper electrode 22 may be formed of a transparent conductor, and may include an inorganic conductive material such as indium tin oxide (ITO), fluorine tin oxide (FTO) or antimony-doped tin oxide (ATO), or an organic conductive material such as polyacetylene or polythiophene.

The light reflecting layer 11 is a layer which reflects light of a wavelength region of about 380nm to about 750nm (reflects light of wavelength at 380nm or 750nm or between 380nm and 750nm), and it is described hereafter with reference to FIG. 2.

Referring to FIG. 2, the light reflecting layer 11 includes a plurality of thin films including a first oxide thin film 11a and a second oxide thin film 11b having a different refractive index from each other and stacked alternately. In one embodiment, the thin films include a number (N) first oxide thin films 11 a and a number (N) of second oxide thin films 11b, and N may be 1 or more. In one embodiment, N is 2 or more. In one embodiment, N is 9.

For example, the first oxide thin film 11a may include titanium oxide ($TiO_2$), and the second oxide thin film 11 b may include silicon oxide ($SiO_2$).

When it is assumed that the number (N) of first oxide thin films 11 a and the number (N) of second oxide thin films 11 b are stacked alternatively (i.e., one of the number (N) of first oxide films 11 a on one of the number (N) of second oxide films 11b), a wavelength region capable of reflecting light may be selected based on the thickness of each layer. In other words, a reflecting wavelength region may be selected by controlling the thickness of each layer.

For example, the thickness may be set to $\lambda/4$ for a particular wavelength, and the thickness may satisfy the following:

$$\text{Thickness } (t_1) = \lambda/4n_1 \text{ ---- (1)}$$

$$\text{Thickness } (t_2) = \lambda/4n_2 \text{ ---- (2)}$$

where $n_1$ denotes a refractive index of titanium oxide; $n_2$ denotes a refractive index of silicon oxide; and $\lambda$

denotes a particular wavelength region.

Each of the first oxide thin film 11a and the second oxide thin film 11 b may be formed in a thickness ranging from about 10nm to about 800nm (at 10nm or 800nm or between 10nm and 800nm), and according to one embodiment, each of the first oxide thin film 11 a and the second oxide thin film 11 b may be formed in a thickness ranging from about 10nm to about 200nm (at 10nm or 200nm or between 10nm and 200nm). Herein, when it is assumed that the first oxide thin film 11 a includes titanium oxide and the second oxide thin film includes silicon oxide, the second oxide thin film 11 b may be formed thicker than the first oxide thin film 11 a.

The auxiliary electrode 13 is a catalyst electrode activating a redox couple. For example, the auxiliary electrode 13 may include Pt, Au, Ni, Cu, Ag, In, Ru, Pd, Rh, Ir, Os, C, a conductive polymer or a combination thereof.

The light absorption layer 23 may include a photosensitive dye and a porous layer with particles adsorbing the photosensitive dye.

The photosensitive dye may be formed of a metal composite including aluminum (Al), platinum (Pt), palladium (Pd), europium (Eu), lead (Pb), iridium (Ir), and ruthenium (Ru). Herein, since ruthenium is an element belonging to a platinum group and is capable of forming many organic metal composites, a dye including ruthenium is used. For example, $Ru(etc\,bpy)_2(NCS)_2 \cdot 2CH3CN$-type is used. Here, in the dye example, "etc" is $(COOEt)_2$ or $(COOH)_2$; and it is a functional group that may be bonded with the surface of the porous layer (e.g., particles of $TiO_2$) Also, a dye including an organic pigment may be used, and non-limiting examples of the organic pigment include coumarin, porphyrin, xanthene, riboflavin, and triphenylmethane. The photoelectric conversion efficiency may be improved by using them alone or together with a Ru composite to improve the visible light absorption of long wavelengths.

The porous layer may include particulates having a fine and uniform nanosized average particle diameter and are distributed uniformly while keeping porosity. The porous layer may have a suitable roughness on its surface. Non-limiting examples of the porous layer may include $TiO_2$, $SnO_2$, $ZnO$, $WO_3$, $Nb_2O_5$, $TiSrO_3$ or a mixture thereof, and among them, anatase-type $TiO_2$ may be used.

Herein, the particulates may allow the porous layer to have a large surface area so that the photosensitive dye adsorbed on the surface may absorb more light. Accordingly, the particulates constituting the porous layer may have a fine average particle diameter ranging from about 5nm to about 500nm (at 5nm or 500nm or between 5nm and 500nm). Since the particulates have an average particle diameter in the above range and according to one embodiment, the surface area is enlarged and this increases the adsorption amount of the photosensitive dye while securing adhesion strength to a substrate structure during a heat treatment that is performed after the porous layer is formed.

The spacer 15 provides an electrolyte impregnation space while preventing (or protecting) a light absorption layer 23 from being pressed during a process for manufacturing a dye-sensitized solar cell.

The electrolyte 30 provides a material promoting an oxidation/reduction reaction of a color-changing electric material, and it may be a liquid electrolyte or a solid polymer electrolyte. As for the liquid electrolyte, a solution (in which a lithium salt such as LiOH or $LiClO_4$, a potassium salt such as KOH, and a sodium salt such as NaOH that are dissolved in a solvent) may be used but this disclosure is not limited thereto. As for the solid electrolyte, poly (2-acrylamino-2-methylpropane sulfonic acid or polyethyleneoxide(poly(ethylene oxide)) may be used, but is not limited thereto.

The dye-sensitized solar cell according to one embodiment of the invention may increase the optical amount absorbed by a dye by including a light reflecting layer opposing a light absorption layer, reflecting the rays not absorbed by the dye of the light absorption layer by the light reflecting layer, and returning them to the light absorption layer. Accordingly, the efficiency of the dye-sensitized solar cell may be improved.

The following examples illustrate aspects of the present invention in more detail. However, it is understood that the present invention is not limited by these examples.

Example 1

A porous titanium dioxide thick film having a thickness of about 18 $\mu$m was formed by coating the upper surface of a fluorine tin oxide (FTO) transparent conductor with a titanium oxide ($TiO_2$) dispersed solution in an area of about $0.2cm^2$ through a Doctor Blade process and performing a heat treatment at about 450 °C for about 30 minutes. Subsequently, specimens were kept at about 80°C to adsorb an Ru based dye (N719 or $C_{58}H_{86}N_8O_8RuS_2$).

A light reflecting layer was formed by depositing titanium oxide ($TiO_2$) and silicon oxide ($SiO_2$) on another FTO transparent conductor to have the thickness of about 69nm and about 106nm, respectively, and this was repeated nine times. Subsequently, an indium tin oxide (ITO) layer was formed on the light reflecting layer to have a thickness of about 200nm through a sputtering method, and then a Pt layer was deposited in a thickness of about 200nm.

Two electrodes were laminated by interposing a thermoplastic polymer film having a thickness of about 60 $\mu$m between the two FTO transparent conductors and compressing them for about 9 seconds at about 100°C. Subsequently, a dye-sensitized solar cell was manufactured by implanting an oxidation-reduction electrolyte into the space between the transparent conductors and hermetically sealing fine pores with a cover glass and the thermoplastic polymer film. The oxidation-reduction electrolyte was prepared by dissolving 0.62 M 1,2-dimethyl-3-hexylimidazolium iodide, 0.5 M 2-aminopyrimidine (2-aminopyrimidine), 0.1 M LiI, and 0.05 M $I_2$ in an acetonitrile solvent.

Example 2

A dye-sensitized solar cell was manufactured according to the same method as Example 1, except that titanium oxide (TiO$_2$) and silicon oxide (SiO$_2$) were repeatedly deposited to have a thickness of about 65nm and about 100nm, respectively, nine times as a light reflecting layer.

Example 3

A dye-sensitized solar cell was manufactured according to the same method as Example 1, except that titanium oxide (TiO$_2$) and silicon oxide (SiO$_2$) were repeatedly deposited to have a thickness of about 61 nm and about 94nm, respectively, nine times as a light reflecting layer.

Example 4

A dye-sensitized solar cell was manufactured according to the same method as Example 1, except that titanium oxide (TiO$_2$) and silicon oxide (SiO$_2$) were repeatedly deposited to have a thickness of about 57nm and about 88nm, respectively, nine times as a light reflecting layer.

Comparative Example 1

A dye-sensitized solar cell was manufactured according to the same method as Example 4, except that no light reflecting layer was included.

Evaluation - 1

The wavelength range reflected by the light reflecting layer of each of the dye-sensitized solar cells manufactured according to Examples 1 to 4 was measured.

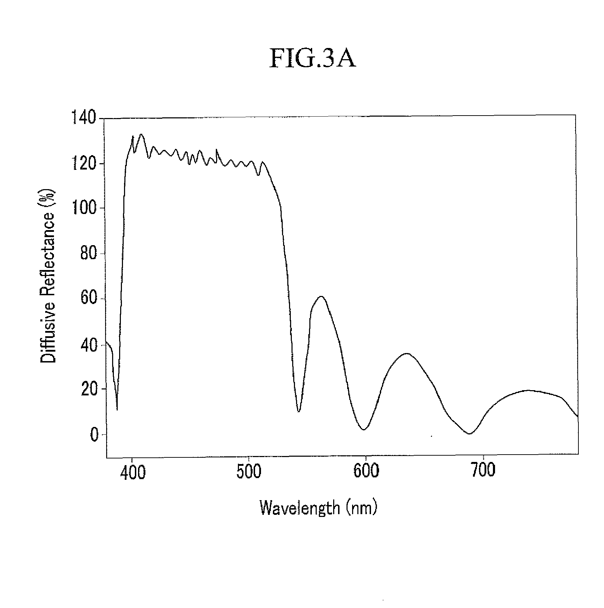

The result is described hereafter with reference to FIGS. 3A to 3D and Table 1.

FIGS. 3A to 3D are graphs showing the optical reflectances (diffusive reflectances) of dye-sensitized solar cells according to Examples 1 to 4.

Table 1

|  | Reflecting wavelength range (nm) |
| --- | --- |
| Example 1 | 400-550 |
| Example 2 | 430-570 |
| Example 3 | 500-680 |
| Example 4 | 530-730 |

It may be seen from FIGS. 3A to 3D and Table 1 that the reflecting wavelength range may be changed by varying the thicknesses of the first oxide thin film and the second oxide thin film which have different refractive indices.

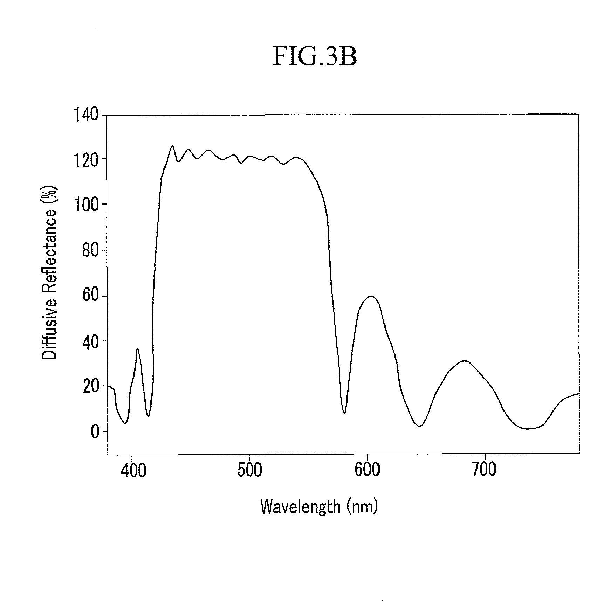

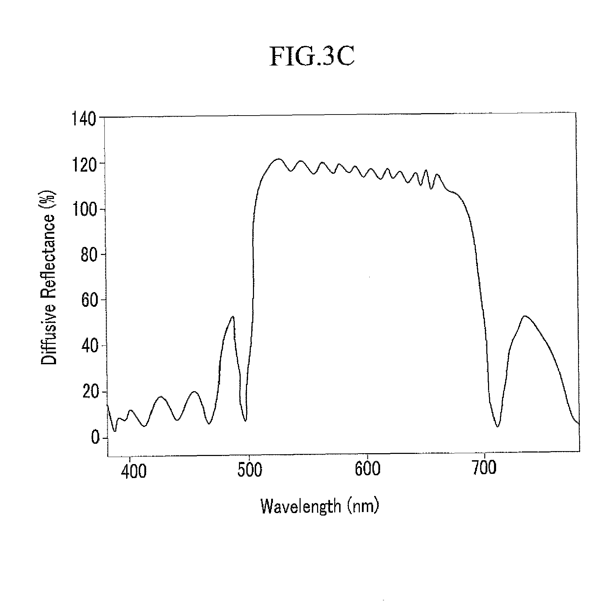

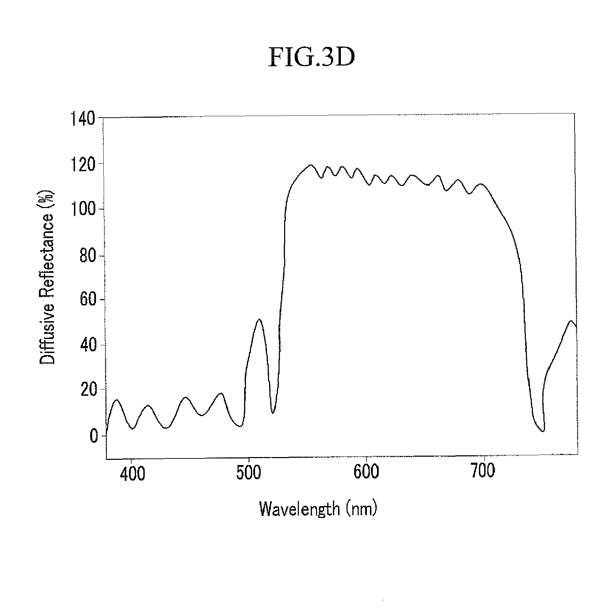

To be specific, FIG. 3A shows that the dye-sensitized solar cell of Example 1 had a reflectance of 100% or higher in the wavelength range of about 400 to about 550nm; FIG. 3B shows that the dye-sensitized solar cell of Example 2 had a reflectance of 100% or higher in the wavelength range of about 430 to about 570nm; FIG. 3C shows that the dye-sensitized solar cell of Example 3 had a reflectance of 100% or higher in the wavelength range of about 500 to about 680 nm; and FIG. 3D shows that the dye-sensitized solar cell of Example 4 had a reflectance of 100% or higher in the wavelength range of about 530 to about 730 nm.

It may be seen from the result that the reflectance may be controlled to be maximized in a particular wavelength by controlling the thicknesses of the first oxide thin film 11 a and the second oxide thin film 11 b which have different refractive indices and were stacked a plurality of times.

Evaluation - 2

The current densities of the dye-sensitized solar cells manufactured according to Example 4 and Comparative Example 1 were measured.

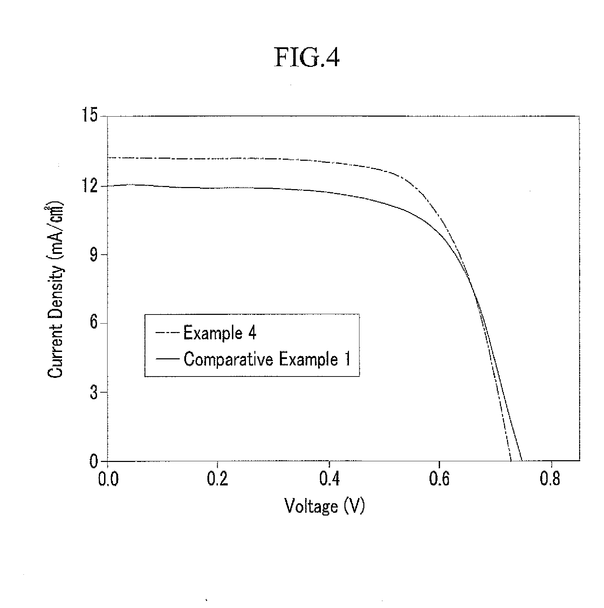

The result was as shown in FIG. 4.

FIG. 4 is a graph showing the current density of the dye-sensitized solar cells according to Example 4 and Comparative Example 1.

It may be seen from FIG. 4 that the dye-sensitized solar cell of Example 4 had higher current density than the dye-sensitized solar cell of Comparative Example 1.

Evaluation - 3

The photocurrent efficiencies (Jsc) (mA/cm$^2$), fill factors (FF) and percent efficiencies (%) of the dye-sensitized solar cells of Example 4 and Comparative Example 1 were measured.

The result was as shown in Table 2.

Table 2

| | Photocurrent efficiency (Jsc) (mA/cm$^2$) | Fill factor (FF) | Efficiency (%) |
|---|---|---|---|
| Example 4 | 13.27 | 0.68 | 6.62 |
| Comparative Example 1 | 12.11 | 0.67 | 6.01 |

Table 2 shows that the dye-sensitized solar cell of Example 4 had improved photocurrent efficiency, fill factor and percent efficiency, compared with the dye-sensitized solar cell of Comparative Example 1. Since the dye-sensitized solar cell of Example 4 includes the light reflecting layer, the light reflected by the light reflecting layer is re-absorbed by the light absorption layer. Therefore, the optical amount is increased and the efficiency of a solar cell is improved.

While the invention has been described in connection with certain embodiments, it is to be understood that the invention is not limited to these embodiments, but, on the contrary, is intended to cover various modifications included within the scope of the appended claims.

**Claims**

1. A dye-sensitized solar cell comprising:

   a first electrode,
   a light absorption layer on one side of the first electrode,
   a second electrode facing the first electrode,
   a light reflecting layer on one side of the second electrode,
   an electrolyte filled between the first electrode and the second electrode,
   wherein the light reflecting layer comprises a plurality of thin films comprising a first oxide thin film and a second oxide thin film, the first oxide thin film having a different refractive index from the second oxide thin film, and the first and second oxide thin films being stacked alternately.

2. A dye-sensitized solar cell according to claim, 1, wherein:

   the first oxide thin film comprises a titanium oxide (TiO$_2$), and
   the second oxide thin film comprises a silicon oxide (SiO$_2$).

3. A dye-sensitized solar cell according to claim 2, wherein each of the first oxide thin film and the second oxide thin film is formed to have a thickness of 10nm or 800nm or between 10nm and 800nm.

4. A dye-sensitized solar cell according to claim 3, wherein the second oxide thin film is formed thicker than the first oxide thin film.

5. A dye-sensitized solar cell according to any preceding claim, wherein the light reflecting layer reflects light having a wavelength of 380nm or 750nm or between 380nm and 750nm.

6. A dye-sensitized solar cell of claim 5, wherein the light reflecting layer has a light reflecting wavelength varying in accordance to the thicknesses of the first oxide thin film and the second oxide thin film.

7. A dye-sensitized solar cell according to any preceding claim, wherein the light reflecting layer has a reflectance that is 100% or higher.

8. A dye-sensitized solar cell according to any preceding claim, wherein the light absorption layer comprises titanium oxide (TiO$_2$) and a photosensitive dye adsorbed to TiO$_2$.

9. A dye-sensitized solar cell according to any preceding claim, wherein the second electrode comprises Pt, Au, Ni, Cu, Ag, In, Ru, Pd, Rh, Ir, Os, C, a conductive polymer or a combination thereof.

10. A dye-sensitized solar cell according to any preceding claim, wherein:

    at least one of the first electrode or the second electrode is supported by a conductive transparent substrate, and

the conductive transparent substrate comprises indium tin oxide, fluorine tin oxide, ZnO-(Ga$_2$O$_3$ or Al$_2$O$_3$), tin oxide, zinc oxide, or a combination thereof.

**11.** A dye-sensitized solar cell according to any preceding claim, wherein:

the first oxide thin film comprises a number (N) of first oxide films,
the second oxide thin film comprises a number (N) of second oxide thin films, and
N is 2 or more.

**12.** A dye-sensitized solar cell according to claim 11, wherein N is 9.

# FIG.1

FIG.2

## FIG.3A

# FIG.3B

# FIG.3C

# FIG.3D

# FIG.4

Europäisches
Patentamt

European
Patent Office

Office européen
des brevets

# EUROPEAN SEARCH REPORT

Application Number

EP 11 18 6589

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | MAURICIO E. CALVO ET AL: "Flexible, Adhesive, and Biocompatible Bragg Mirrors Based on Polydimethylsiloxane Infiltrated Nanoparticle Multilayers", CHEMISTRY OF MATERIALS, vol. 22, no. 13, 13 July 2010 (2010-07-13), pages 3909-3915, XP55014999, ISSN: 0897-4756, DOI: 10.1021/cm1001016 * the whole document * & SILVIA COLODRERO ET AL: "Porous One-Dimensional Photonic Crystals Improve the Power-Conversion Efficiency of Dye-Sensitized Solar Cells", ADVANCED MATERIALS, WILEY VCH VERLAG, DE, vol. 21, no. 7, 1 January 2009 (2009-01-01), pages 764-770, XP007914262, ISSN: 0935-9648, DOI: 10.1002/ADMA.200703115 [retrieved on 2008-12-16] * section "experimental" * | 1-12 | INV. G02B5/08 H01G9/20 H01L51/42 H01M14/00 |
| | ----- | | |
| Y | US 2009/126789 A1 (LI CHUNG-HUA [TW] ET AL) 21 May 2009 (2009-05-21) * abstract * * figure 7 * * paragraph [0012] - paragraph [0019] * * paragraph [0039] - paragraph [0041] * | 1-12 | TECHNICAL FIELDS SEARCHED (IPC) B82Y G02B H01G H01L H01M |
| | ----- | | |
| Y | EP 2 073 045 A1 (CONSEJO SUPERIOR INVESTIGACION [ES]; CONSEJO NAC DE INVESTIGACINES [AR]) 24 June 2009 (2009-06-24) * abstract * * figures 1-6 * * paragraph [0001] - paragraph [0026] * * paragraph [0028] - paragraph [0062] * | 1-12 | |
| | ----- | | |
| | -/-- | | |

The present search report has been drawn up for all claims

| Place of search | Date of completion of the search | Examiner |
|---|---|---|
| The Hague | 16 December 2011 | De Kroon, Arnoud |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

**EUROPEAN SEARCH REPORT**

Application Number

EP 11 18 6589

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | WO 2009/127692 A2 (NANOLOGICA AB [SE]; MIGUEZ HERNAN [ES]; COLODRERO SILVIA [ES]) 22 October 2009 (2009-10-22) * abstract * * figures 1-7 * * page 1, line 1 - page 5, line 3 * * page 7, line 1 - page 16, line 3 * ----- | 1-6,8-11 | |
| A | EP 1 562 205 A1 (SAMSUNG SDI CO LTD [KR]) 10 August 2005 (2005-08-10) * the whole document * ----- | 1-12 | |

TECHNICAL FIELDS
SEARCHED      (IPC)

The present search report has been drawn up for all claims

| Place of search | Date of completion of the search | Examiner |
|---|---|---|
| The Hague | 16 December 2011 | De Kroon, Arnoud |

EPO FORM 1503 03.82 (P04C01)

**ANNEX TO THE EUROPEAN SEARCH REPORT
ON EUROPEAN PATENT APPLICATION NO.**

EP 11 18 6589

This annex lists the patent family members relating to the patent documents cited in the above-mentioned European search report.
The members are as contained in the European Patent Office EDP file on
The European Patent Office is in no way liable for these particulars which are merely given for the purpose of information.

16-12-2011

| Patent document cited in search report | | | Publication date | Patent family member(s) | | | Publication date |
|---|---|---|---|---|---|---|---|
| US 2009126789 | A1 | | 21-05-2009 | TW | 200919743 | A | 01-05-2009 |
| | | | | US | 2009126789 | A1 | 21-05-2009 |
| EP 2073045 | A1 | | 24-06-2009 | EP | 2073045 | A1 | 24-06-2009 |
| | | | | ES | 2296533 | A1 | 16-04-2008 |
| | | | | US | 2011149400 | A1 | 23-06-2011 |
| | | | | WO | 2008034932 | A1 | 27-03-2008 |
| WO 2009127692 | A2 | | 22-10-2009 | AU | 2009237663 | A1 | 22-10-2009 |
| | | | | CN | 102027556 | A | 20-04-2011 |
| | | | | EP | 2263244 | A2 | 22-12-2010 |
| | | | | JP | 2011517839 | A | 16-06-2011 |
| | | | | US | 2011030792 | A1 | 10-02-2011 |
| | | | | WO | 2009127692 | A2 | 22-10-2009 |
| EP 1562205 | A1 | | 10-08-2005 | AT | 391999 | T | 15-04-2008 |
| | | | | DE | 602005005868 | T2 | 10-06-2009 |
| | | | | EP | 1562205 | A1 | 10-08-2005 |
| | | | | JP | 4362111 | B2 | 11-11-2009 |
| | | | | JP | 2005222941 | A | 18-08-2005 |
| | | | | KR | 20050078856 | A | 08-08-2005 |
| | | | | US | 2005166959 | A1 | 04-08-2005 |

EPO FORM P0459

For more details about this annex : see Official Journal of the European Patent Office, No. 12/82